# EUROPEAN PATENT APPLICATION

(11) **EP 3 438 746 A1**
(43) Date of publication of application: **06.02.2019**
(21) Application number: 17774455.4
(22) Date of filing: 17.03.2017
(51) Int. Cl.: G03F 7/023, C08L 63/00, C08L 65/00, G03F 7/004, G03F 7/075

(54) **RADIATION SENSITIVE RESIN COMPOSITION AND ELECTRONIC COMPONENT**

(30) Priority: 28.03.2016 JP 2016063916
(71) Applicant: Zeon Corporation, Tokyo 100-8246 (JP)
(72) Inventor: TSUTSUMI, Takashi, Tokyo 100-8246 (JP); FUJIMURA, Makoto, Tokyo 100-8246 (JP)
(74) Representative: Maiwald Patent- und Rechtsanwaltsgesellschaft mbH
(86) International application number: PCT/JP2017/010961
(87) International publication number: WO 2017/169914

(57) **Abstract**

A radiation-sensitive resin composition comprising a cyclic olefin polymer (A) having a protonic polar group, a bifunctional epoxy compound (B) represented by the following general formula (1), and a radiation-sensitive compound (C): 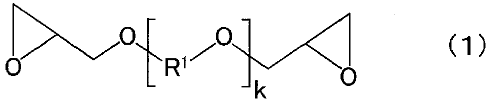 wherein, in the above general formula (1), R¹ is a linear chain or branched alkylene group having 1 to 15 carbon atoms, and "k" is an integer of 1 to 20, is provided.

## Description

### TECHNICAL FIELD

The present invention relates to a radiation-sensitive resin composition and to an electronic device provided with a resin film comprised of this radiation-sensitive resin composition, more particularly relates to a radiation-sensitive resin composition able to give a resin film low in elastic modulus, suppressed in occurrence of warping due to this, and excellent in thermal shock resistance and developability and to an electronic device provided with a resin film comprised of this radiation-sensitive resin composition

### BACKGROUND ART

Various display devices such as organic EL devices and liquid crystal display devices, integrated circuit devices, solid state imaging devices, color filters, black matrices, and other electronic devices have various resin films as surface protective films for preventing degradation or damage, flattening films for flattening the device surfaces and interconnects, interlayer insulating films for insulating between interconnects laid out in layers, etc.

In the past, as the resin materials for forming these resin films, thermosetting resin materials such as epoxy resins have been widely used. In recent years, along with the higher densities of interconnects and devices, in these resin materials as well, development of new resin materials excellent in electrical characteristics such as a low dielectric property has been sought.

To deal with these demands, for example, Patent Document 1 discloses a radiation-sensitive resin composition comprising a binder resin (A), a radiation-sensitive compound (B), an epoxy-based cross-linking agent (C) with an epoxy equivalent of 450 or less, a softening point of 30°C or less, and four functions or less, and an arakyl phenol resin (D). However, according to the radiation-sensitive resin composition described in Patent Document 1, a resin film excellent in electrical characteristics such as a low dielectric property and further excellent in developability can be formed, but sometimes the elastic modulus of the obtained resin film is high and warping ends up occurring due to curing at the time of formation of the resin film. For this reason, from the viewpoint of improvement of the reliability, improvement has been desired.

### RELATED ART DOCUMENTS

### PATENT DOCUMENTS

Patent Document 1: WO2015/141717A

### SUMMARY OF THE INVENTION

### PROBLEM TO BE SOLVED BY THE INVENTION

The present invention has as its object the provision of a radiation-sensitive resin composition able to give a resin film low in elastic modulus, suppressed in occurrence of warping due to this, and excellent in thermal shock resistance and developability and to an electronic device provided with a resin film comprised of this radiation-sensitive resin composition

### MEANS FOR SOLVING THE PROBLEM

The inventors engaged in intensive research for achieving the above object and as a result discovered that the above object can be achieved by a resin composition obtained by mixing a specific bifunctional epoxy compound and a radiation-sensitive compound into a cyclic olefin polymer having a protonic polar group and thereby completed the present invention.

That is, according to the present invention, there are provided:
[1] A radiation-sensitive resin composition comprising a cyclic olefin polymer (A) having a protonic polar group, a bifunctional epoxy compound (B) represented by the following general formula (1), and a radiation-sensitive compound (C): 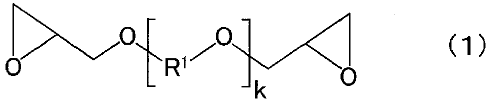 where, in the general formula (1), R¹ is a linear chain or branched alkylene group having 1 to 15 carbon atoms and "k" is an integer of 1 to 20,
[2] The radiation-sensitive resin composition according to [1],
   wherein a content of the epoxy compound (B) is 8 to 150 parts by weight with respect to 100 parts by weight of the cyclic olefin polymer (A) having a protonic polar group,
[3] The radiation-sensitive resin composition according to [1] or [2], wherein an epoxy equivalent of the epoxy compound (B) is 100 to 1000,
[4] The radiation-sensitive resin composition according to any one of [1] to [3], wherein a softening point of the epoxy compound (B) is 40°C or less,
[5] The radiation-sensitive resin composition according to any one of [1] to [4] further comprising a compound including two or more alkoxymethyl groups or methylol groups in its molecule,
[6] The radiation-sensitive resin composition according to any one of [1] to [5] further comprising an epoxy compound having an alicyclic structure,
[7] The radiation-sensitive resin composition according to any one of [1] to [6] further comprising a silane coupling agent, and
[8] An electronic device provided with a resin film comprised of a radiation-sensitive resin composition according to any one of [1] to [7].

### EFFECTS OF THE INVENTION

According to the present invention, it is possible to provide a radiation-sensitive resin composition able to give a resin film low in elastic modulus, suppressed in occurrence of warping due to this, and excellent in thermal shock resistance and developability and an electronic device provided with a resin film comprised of this radiation-sensitive resin composition.

### DESCRIPTION OF EMBODIMENTS

The radiation-sensitive resin composition of the present invention comprises a cyclic olefin polymer (A) having a protonic polar group, a bifunctional epoxy compound (B) represented by the later-described general formula (1), and a radiation-sensitive compound (C).

### (Cyclic Olefin Polymer (A) Having Protonic Polar Group)

As the cyclic olefin polymer which has a protonic polar group (A) (below, simply referred to as the "cyclic olefin polymer (A)"), a polymer of one or more cyclic olefin monomers or a copolymer of one or more cyclic olefin monomers and a monomer which can copolymerize with them may be mentioned, but in the present invention, as the monomer for forming the cyclic olefin polymer (A), it is preferable to use at least a cyclic olefin monomer which has a protonic polar group (a).

Here, the "protonic polar group" means a group which contains an atom belonging to Group XV or Group XVI of the Periodic Table to which a hydrogen atom directly bonds. Among the atoms belonging to Group XV or Group XVI of the Periodic Table, atoms belonging to Period 1 or Period 2 of Group XV or Group XVI of the Periodic Table are preferable, an oxygen atom, nitrogen atom, or sulfur atom is more preferable, and an oxygen atom is particularly preferable.

As specific examples of such a protonic polar group, a hydroxyl group, carboxy group (hydroxycarbonyl group), sulfonic acid group, phosphoric acid group, and other polar groups which have oxygen atoms; primary amino group, secondary amino group, primary amide group, secondary amide group (imide group), and other polar groups which have nitrogen atoms; a thiol group and other polar groups which have sulfur atoms; etc. may be mentioned. Among these as well, ones which have oxygen atoms are preferable, carboxy group is more preferable.

In the present invention, the number of protonic polar groups which bond with the cyclic olefin resin which has protonic polar groups is not particularly limited. Further, different types of protonic polar groups may also be included.

As specific examples of the cyclic olefin monomer which has a protonic polar group (a) (below, suitably called the "monomer (a)"), a carboxy group-containing cyclic olefin such as 2-hydroxycarbonylbicyclo[2.2.1]hept-5-ene, 2-methyl-2-hydroxycarbonylbicyclo[2.2.1]hept-5-ene, 2-carboxymethyl-2-hydroxycarbonylbicyclo[2.2.1]hept-5-ene, 2-hydroxycarbonyl-2-methoxycarbonylmethylbicyclo[2.2.1]hept-5-ene, 2-hydroxycarbonyl-2-ethoxycarbonylmethylbicyclo[2.2.1]hept-5-ene, 2-hydroxycarbonyl-2-propoxycarbonylmethylbicyclo[2.2.1]hept-5-ene, 2-hydroxycarbonyl-2-butoxycarbonylmethylbicyclo[2.2.1]hept-5-ene, 2-hydroxycarbonyl-2-pentyloxycarbonylmethylbicyclo[2.2.1]hept-5-ene, 2-hydroxycarbonyl-2-hexyloxycarbonylmethylbicyclo[2.2.1]hept-5-ene, 2-hydroxycarbonyl-2-cyclohexyloxycarbonylmethylbicyclo[2.2.1]hept-5-ene, 2-hydroxycarbonyl-2-phenoxycarbonylmethylbicyclo[2.2.1]hept-5-ene, 2-hydroxycarbonyl-2-naphthyloxycarbonylmethylbicyclo[2.2.1]hept-5-ene, 2-hydroxycarbonyl-2-biphenyloxycarbonylmethylbicyclo[2.2.1]hept-5-ene, 2-hydroxycarbonyl-2-benzyloxycarbonylmethylbicyclo[2.2.1]hept-5-ene, 2-hydroxycarbonyl-2-hydroxyethoxycarbonylmethylbicyclo[2.2.1]hept-5-ene, 2,3-dihydroxycarbonylbicyclo[2.2.1]hept-5-ene, 2-hydroxycarbonyl-3-methoxycarbonylbicyclo[2.2.1]hept-5-ene, 2-hydroxycarbonyl-3-ethoxycarbonylbicyclo[2.2.1]hept-5-ene, 2-hydroxycarbonyl-3-propoxycarbonylbicyclo[2.2.1]hept-5-ene, 2-hydroxycarbonyl-3-butoxycarbonylbicyclo[2.2.1]hept-5-ene, 2-hydroxycarbonyl-3-pentyloxycarbonylbicyclo[2.2.1]hept-5-ene, 2-hydroxycarbonyl-3-hexyloxycarbonylbicyclo[2.2.1]hept-5-ene, 2-hydroxycarbonyl-3-cyclohexyloxycarbonylbicyclo[2.2.1]hept-5-ene, 2-hydroxycarbonyl-3-phenoxycarbonylbicyclo[2.2.1]hept-5-ene, 2-hydroxycarbonyl-3-naphthyloxycarbonylbicyclo[2.2.1]hept-5-ene, 2-hydroxycarbonyl-3-biphenyloxycarbonylbicyclo[2.2.1]hept-5-ene, 2-hydroxycarbonyl-3-benzyloxycarbonylbicyclo[2.2.1]hept-5-ene, 2-hydroxycarbonyl-3-hydroxyethoxycarbonylbicyclo[2.2.1]hept-5-ene, 2-hydroxycarbonyl-3-hydroxycarbonylmethylbicyclo[2.2.1]hept-5-ene, 3-methyl-2-hydroxycarbonylbicyclo[2.2.1]hept-5-ene, 3-hydroxymethyl-2-hydroxycarbonylbicyclo[2.2.1]hept-5-ene, 2-hydroxycarbonyltricyclo[5.2.1.0^{2,6}]deca-3,8-diene, 4-hydroxycarbonyltetracyclo[6.2.1.1^{3,6}.0^{2,7}]dodec-9-ene, 4-methyl-4-hydroxycarbonyltetracyclo[6.2.1.1^{3,6}.0^{2,7}]dodec-9-ene, 4,5-dihydroxycarbonyltetracyclo[6.2.1.1^{3,6}.0^{2,7}]dodec-9-ene, 4-carboxymethyl-4-hydroxycarbonyltetracyclo[6.2.1.1^{3,6}.0^{2,7}]dodec-9-ene, N-(hydroxycarbonylmethyl)bicyclo[2.2.1]hept-5-ene-2,3-dicarboxyimide, N-(hydroxycarbonylethyl)bicyclo[2.2.1]hept-5-ene-2,3-dicarboxyimide, N-(hydroxycarbonylpentyl)bicyclo[2.2.1]hept-5-ene-2,3-dicarboxyimide, N-(dihydroxycarbonylethyl)bicyclo[2.2.1]hept-5-ene-2,3-dicarboxyimide, N-(dihydroxycarbonylpropyl)bicyclo[2.2.1]hept-5-ene-2,3-dicarboxyimide, N-(hydroxycarbonylphenethyl)bicyclo[2.2.1]hept-5-ene-2,3-dicarboxyimide, N-(2-(4-hydroxyphenyl)-1-(hydroxycarbonyl)ethyl)bicyclo[2.2.1]hept-5-ene-2,3-dicarboxyimide, and N-(hydroxycarbonylphenyl)bicyclo[2.2.1]hept-5-ene-2,3-dicarboxyimide; a hydroxyl group-containing cyclic olefin such as 2-(4-hydroxyphenyl)bicyclo[2.2.1]hept-5-ene, 2-methyl-2-(4-hydroxyphenyl)bicyclo[2.2.1]hept-5-ene, 4-(4-hydroxyphenyl)tetracyclo[6.2.1.1^{3,6}.0^{2,7}]dodec-9-ene, 4-methyl-4- (4-hydroxyphenyl)tetracyclo[6.2.1.1^{3,6}.0^{2,7}]dodec- 9-ene, 2-hydroxybicyclo[2.2.1]hept-5-ene, 2-hydroxymethylbicyclo[2.2.1]hept-5-ene, 2-hydroxyethylbicyclo[2.2.1]hept-5-ene, 2-methyl-2-hydroxymethylbicyclo[2.2.1]hept-5-ene, 2,3-dihydroxymethylbicyclo[2.2.1]hept-5-ene, 2-(hydroxyethoxycarbonyl)bicyclo[2.2.1]hept-5-ene, 2-methyl-2-(hydroxyethoxycarbonyl)bicyclo[2.2.1]hept-5-ene, 2-(1-hydroxy-1-trifluoromethyl-2,2,2-trifluoroethyl)bicycle[2.2.1]hept-5-ene, 2-(2-hydroxy-2-trifluoromethyl-3,3,3-trifluoropropyl)bicyclo[2.2.1]hept-5-ene, 3-hydroxytricyclo[5.2.1.0^{2,6}]deca-4,8-diene, 3-hydroxymethyltricyclo[5.2.1.0^{2,6}]deca-4,8-diene, 4-hydroxytetracyclo[6.2.1.1^{3,6}.0^{2,7}]dodec-9-ene, 4-hydroxymethyltetracyclo[6.2.1.1^{3,6}.0^{2,7}]dodec-9-ene, 4,5-dihydroxymethyltetracyclo[6.2.1.1^{3,6}.0^{2,7}]dodec-9-ene, 4-(hydroxyethoxycarbonyl)tetracyclo[6.2.1.1^{3,6}.0^{2,7}]dodec-9-ene, 4-methyl-4-(hydroxyethoxycarbonyl)tetracyclo[6.2.1.1^{3,6}.0^{2,7}]dodec-9-ene, N-(hydroxyethyl)bicyclo[2.2.1]hept-5-ene-2,3-dicarboxyimide, and N-(hydroxyphenyl)bicyclo[2.2.1]hept-5-ene-2,3-dicarboxyimide etc. may be mentioned. Among these as well, from the viewpoint of the adhesion of the obtained resin film which is obtained by using a radiation-sensitive resin composition of the present invention becoming higher, carboxy group-containing cyclic olefins are preferable, while 4-hydroxycarbonyltetracyclo[6.2.1.1^{3,6}.0^{2,7}]dodec-9-ene is particularly preferable. These monomers (a) may respectively be used alone or may be used as two types or more combined.

In the cyclic olefin polymer (A1), the ratio of content of the units of the monomer (a) is preferably 10 to 90 mol% with respect to all monomer units, more preferably 20 to 80 mol%, still more preferably 30 to 70 mol%. If the content of the units of the monomer (a) is too small, dissolution residue is liable to be generated when developing. If the content of the units of the monomer (a) is too large, the cyclic olefin polymer (A1) is liable to become insufficient in the solubility in a polar solvent.

Further, the cyclic olefin polymer (A) used in the present invention may be a copolymer which is obtained by copolymerization of a cyclic olefin monomer which has a protonic polar group (a) and a monomer (b) which can copolymerize with this. As such a copolymerizable monomer, a cyclic olefin monomer which has a polar group other than a protonic polar group (b1), a cyclic olefin monomer which does not have a polar group (b2), and a monomer other than a cyclic olefin (b3) (below, suitably called the "monomer (b1)", "monomer (b2)", and "monomer (b3)") may be mentioned.

As the cyclic olefin monomer which has a polar group other than a protonic polar group (b1), for example, a cyclic olefin which has an N-substituted imide group, ester group, cyano group, acid anhydride group, or halogen atom may be mentioned.

As a cyclic olefin which has an N-substituted imide group, for example, a monomer represented by the following formula (2) or a monomer represented by the following formula (3) may be mentioned.

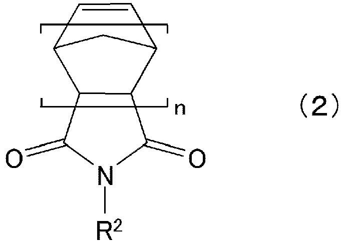

(In the above formula (2), R² indicates a hydrogen atom or alkyl group or aryl group having 1 to 16 carbon atoms. "n" indicates an integer of 1 to 2.)

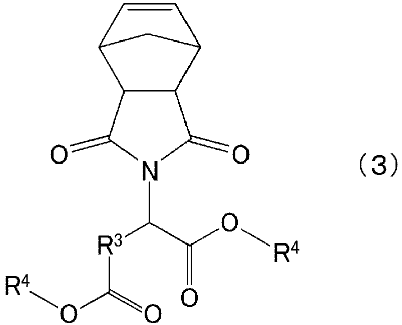

(In the above formula (3), R³ indicates a bivalent alkylene group having 1 to 3 carbon atoms, while R⁴ indicates a monovalent alkyl group having 1 to 10 carbon atoms or a monovalent halogenated alkyl group having 1 to 10 carbon atoms.)

In the above formula (2), R² is an alkyl group or aryl group having 1 to 16 carbon atoms. As specific examples of the alkyl group, a methyl group, ethyl group, n-propyl group, n-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, and other straight chain alkyl groups; cyclopropyl group, cyclobutyl group, cyclopentyl group, cyclohexyl group, cycloheptyl group, cyclooctyl group, cyclononyl group, cyclodecyl group, cycloundecyl group, cyclododecyl group, norbornyl group, bornyl group, isobornyl group, decahydronaphthyl group, tricyclodecanyl group, adamantyl group, and other cyclic alkyl groups; 2-propyl group, 2-butyl group, 2-methyl-1-propyl group, 2-methyl-2-propyl group, 1-methylbutyl group, 2-methylbutyl group, 1-methylpentyl group, 1-ethylbutyl group, 2-methylhexyl group, 2-ethylhexyl group, 4-methylheptyl group, 1-methylnonyl group, 1-methyltridecyl group, 1-methyltetradecyl group, and other branched alkyl groups; etc. may be mentioned. Further, as specific examples of the aryl group, a benzyl group etc. may be mentioned. Among these as well, due to the more excellent heat resistance and solubility in a polar solvent, an alkyl group and aryl group having 1 to 14 carbon atoms are preferable, while an alkyl group and aryl group having 6 to 10 carbon atoms are more preferable. If the number of carbon atoms is 4 or less, the solubility in a polar solvent is inferior, while if the number of carbon atoms is 17 or more, the heat resistance is inferior. Further, when patterning the resin film, there is the problem that the resin film melts by heat and the patterns to end up disappearing.

As specific examples of the monomer represented by the above general formula (2), bicyclo[2.2.1]hept-5-ene-2,3-dicarboxyimide, N-phenyl-bicyclo[2.2.1]hept-5-ene-2,3-dicarboxyimide, N-methylbicyclo[2.2.1]hept-5-ene-2,3-dicarboxyimide, N-ethylbicyclo[2.2.1]hept-5-ene-2,3-dicarboxyimide, N-propylbicyclo[2.2.1]hept-5-ene-2,3-dicarboxyimide, N-butylbicyclo[2.2.1]hept-5-ene-2,3-dicarboxyimide, N-cyclohexylbicyclo[2.2.1]hept-5-ene-2,3-dicarboxyimide, N-adamantylbicyclo[2.2.1]hept-5-ene-2,3-dicarboxyimide, N-(1-methylbutyl)-bicyclo[2.2.1]hept-5-ene-2,3-dicarboxyimide, N-(2-methylbutyl)-bicyclo[2.2.1]hept-5-ene-2,3-dicarboxyimide, N-(1-methylpentyl)-bicyclo[2.2.1]hept-5-ene-2,3-dicarboxyimide, N-(2-methylpentyl)-bicyclo[2.2.1]hept-5-ene-2,3-dicarboxyimide, N-(1-ethylbutyl)-bicyclo[2.2.1]hept-5-ene-2,3-dicarboxyimide, N-(2-ethylbutyl)-bicyclo[2.2.1]hept-5-ene-2,3-dicarboxyimide, N-(1-methylhexyl)-bicyclo[2.2.1]hept-5-ene-2,3-dicarboxyimide, N-(2-methylhexyl)-bicyclo[2.2.1]hept-5-ene-2,3-dicarboxyimide, N-(3-methylhexyl)-bicyclo[2.2.1]hept-5-ene-2,3-dicarboxyimide, N-(1-butylpentyl)-bicyclo[2.2.1]hept-5-ene-2,3-dicarboxyimide, N-(2-butylpentyl)-bicyclo[2.2.1]hept-5-ene-2,3-dicarboxyimide, N-(1-methylheptyl)-bicyclo[2.2.1]hept-5-ene-2,3-dicarboxyimide, N-(2-methylheptyl)-bicyclo[2.2.1]hept-5-ene-2,3-dicarboxyimide, N-(3-methylheptyl)-bicyclo[2.2.1]hept-5-ene-2,3-dicarboxyimide, N-(4-methylheptyl)-bicyclo[2.2.1]hept-5-ene-2,3-dicarboxyimide, N-(1-ethylhexyl)-bicyclo[2.2.1]hept-5-ene-2,3-dicarboxyimide, N-(2-ethylhexyl)-bicyclo[2.2.1]hept-5-ene-2,3-dicarboxyimide, N-(3-ethylhexyl)-bicyclo[2.2.1]hept-5-ene-2,3-dicarboxyimide, N-(1-propylpentyl)-bicyclo[2.2.1]hept-5-ene-2,3-dicarboxyimide, N-(2-propylpentyl)-bicyclo[2.2.1]hept-5-ene-2,3-dicarboxyimide, N-(1-methyloctyl)-bicyclo[2.2.1]hept-5-ene-2,3-dicarboxyimide, N-(2-methyloctyl)-bicyclo[2.2.1]hept-5-ene-2,3-dicarboxyimide, N-(3-methyloctyl)-bicyclo[2.2.1]hept-5-ene-2,3-dicarboxyimide, N-(4-methyloctyl)-bicyclo[2.2.1]hept-5-ene-2,3-dicarboxyimide, N-(1-ethylheptyl)-bicyclo[2.2.1]hept-5-ene-2,3-dicarboxyimide, N-(2-ethylheptyl)-bicyclo[2.2.1]hept-5-ene-2,3-dicarboxyimide, N-(3-ethylheptyl)-bicyclo[2.2.1]hept-5-ene-2,3-dicarboxyimide, N-(4-ethylheptyl)-bicyclo[2.2.1]hept-5-ene-2,3-dicarboxyimide, N-(1-propylhexyl)-bicyclo[2.2.1]hept-5-ene-2,3-dicarboxyimide, N-(2-propylhexyl)-bicyclo[2.2.1]hept-5-ene-2,3-dicarboxyimide, N-(3-propylhexyl)-bicyclo[2.2.1]hept-5-ene-2,3-dicarboxyimide, N-(1-methylnonyl)-bicyclo[2.2.1]hept-5-ene-2,3-dicarboxyimide, N-(2-methylnonyl)-bicyclo[2.2.1]hept-5-ene-2,3-dicarboxyimide, N-(3-methylnonyl)-bicyclo[2.2.1]hept-5-ene-2,3-dicarboxyimide, N-(4-methylnonyl)-bicyclo[2.2.1]hept-5-ene-2,3-dicarboxyimide, N-(5-methylnonyl)-bicyclo[2.2.1]hept-5-ene-2,3-dicarboxyimide, N-(1-ethyloctyl)-bicyclo[2.2.1]hept-5-ene-2,3-dicarboxyimide, N-(2-ethyloctyl)-bicyclo[2.2.1]hept-5-ene-2,3-dicarboxyimide, N-(3-ethyloctyl)-bicyclo[2.2.1]hept-5-ene-2,3-dicarboxyimide, N-(4-ethyloctyl)-bicyclo[2.2.1]hept-5-ene-2,3-dicarboxyimide, N-(1-methyldecyl)-bicyclo[2.2.1]hept-5-ene-2,3-dicarboxyimide, N-(1-methyldodecyl)-bicyclo[2.2.1]hept-5-ene-2,3-dicarboxyimide, N-(1-methylundecyl)-bicyclo[2.2.1]hept-5-ene-2,3-dicarboxyimide, N-(1-methyldodecyl)-bicyclo[2.2.1]hept-5-ene-2,3-dicarboxyimide, N-(1-methyltridecyl)-bicyclo[2.2.1]hept-5-ene-2,3-dicarboxyimide, N-(1-methyltetradecyl)-bicyclo[2.2.1]hept-5-ene-2,3-dicarboxyimide, N-(1-methylpentadecyl)-bicyclo[2.2.1]hept-5-ene-2,3-dicarboxyimide, N-phenyl-tetracyclo[6.2.1.1^{3,6}.0^{2,7}]dodec-9-ene-4,5-dicarboxyimide, N-(2,4-dimethoxyphenyl)-tetracyclo[6.2.1.1^{3,6}.0^{2,7}]dodec-9-ene-4,5-dicarboxyimide, etc. may be mentioned. Note that, these may respectively be used alone or may be used as two types or more combined.

On the other hand, in the above formula (3), R³ is a bivalent alkylene group having 1 to 3 carbon atoms. As the bivalent alkylene group having 1 to 3 carbon atoms, a methylene group, ethylene group, propylene group, and isopropylene group may be mentioned. Among these as well, due to the excellent polymerization activity, a methylene group and ethylene group are preferable.

Further, in the above formula (3), R⁴ is a monovalent alkyl group having 1 to 10 carbon atoms or monovalent halogenated alkyl group having 1 to 10 carbon atoms. As the monovalent alkyl group having 1 to 10 carbon atoms, for example, a methyl group, ethyl group, propyl group, isopropyl group, butyl group, sec-butyl group, tert-butyl group, hexyl group, cyclohexyl group, etc. may be mentioned. As the monovalent halogenated alkyl group having 1 to 10 carbon atoms, for example, a fluoromethyl group, chloromethyl group, bromomethyl group, difluoromethyl group, dichloromethyl group, difluoromethyl group, trifluoromethyl group, trichloromethyl group, 2,2,2-trifluoroethyl group, pentafluoroethyl group, heptafluoropropyl group, perfluorobutyl group, perfluoropentyl group, etc. may be mentioned. Among these as well, since the solubility in a polar solvent is excellent, as R⁴, a methyl group or ethyl group is preferable.

Note that, the monomer represented by the above formulas (2) and (3) can, for example, be obtained by an imidization reaction between a corresponding amine and 5-norbornene-2,3-dicarboxylic acid anhydride. Further, the obtained monomer can be efficiently isolated by separating and refining the reaction solution of the imidization reaction by a known method.

As the cyclic olefin which has an ester group, for example, 2-acetoxybicyclo[2.2.1]hept-5-ene, 2-acetoxymethylbicyclo[2.2.1]hept-5-ene, 2-methoxycarbonylbicyclo[2.2.1]hept-5-ene, 2-ethoxycarbonylbicyclo[2.2.1]hept-5-ene, 2-propoxycarbonylbicyclo[2.2.1]hept-5-ene, 2-butoxycarbonylbicyclo[2.2.1]hept-5-ene, 2-cyclohexyloxycarbonylbicyclo[2.2.1]hept-5-ene, 2-methyl-2-methoxycarbonylbicyclo[2.2.1]hept-5-ene, 2-methyl-2-ethoxycarbonylbicyclo[2.2.1]hept-5-ene, 2-methyl-2-propoxycarbonylbicyclo[2.2.1]hept-5-ene, 2-methyl-2-butoxycarbonylbicyclo[2.2.1]hept-5-ene, 2-methyl-2-cyclohexyloxycarbonylbicyclo[2.2.1]hept-5-ene, 2-(2,2,2-trifluoroethoxycarbonyl)bicyclo[2.2.1]hept-5-ene, 2-methyl-2-(2,2,2-trifluoroethoxycarbonyl)bicyclo[2.2.1]hept-5-ene, 2-methoxycarbonyltricyclo[5.2.1.0^{2,6}]dec-8-ene, 2-ethoxycarbonyltricyclo [5.2.1.0^{2,6}]dec-8-ene, 2-propoxycarbonyltricyclo[5.2.1.0^{2,6}]dec-8-ene, 4-acetoxytetracyclo [6.2.1.1^{3,6}.0^{2,7}] dodec-9-ene, 4-methoxycarbonyltetracyclo[6.2.1.1^{3,6}.0^{2,7}]dodec-9-ene, 4-ethoxycarbonyltetracyclo[6.2.1.1^{3,6}.0^{2,7}]dodec-9-ene, 4-propoxycarbonyltetracyclo[6.2.1.1^{3,6}.0^{2,7}]dodec-9-ene, 4-butoxycarbonyltetracyclo[6.2.1.1^{3,6}.0^{2,7}]dodec-9-ene, 4-methyl-4-methoxycarbonyltetracyclo[6.2.1.1^{3,6}.0^{2,7}]dodec-9-ene, 4-methyl-4-ethoxycarbonyltetracyclo[6.2.1.1^{3,6}.0^{2,7}]dodec-9-ene, 4-methyl-4-propoxycarbonyltetracyclo[6.2.1.1^{3,6}.0^{2,7}]dodec-9-ene, 4-methyl-4-butoxycarbonyltetracyclo[6.2.1.1^{3,6}.0^{2,7}]dodec-9-ene, 4- (2,2,2-trifluoroethoxycarbonyl)tetracyclo[6.2.1.1^{3,6}.0^{2,7}]dodec-9-ene, 4-methyl-4-(2,2,2-trifluoroethoxycarbonyl)tetracyclo[6.2.1.1^{3,6}.0^{2,7}]dodec-9-ene, etc. may be mentioned.

As the cyclic olefin which has a cyano group, for example, 4-cyanotetracyclo[6.2.1.1^{3,6}.0^{2,7}]dodec-9-ene, 4-methyl-4-cyanotetracyclo[6.2.1.1^{3,6}.0^{2,7}]dodec-9-ene, 4,5-dicyanotetracyclo[6.2.1.1^{3,6}.0^{2,7}]dodec-9-ene, 2-cyanobicyclo[2.2.1]hept-5-ene, 2-methyl-2-cyanobicyclo[2.2.1]hept-5-ene, 2,3-dicyanobicyclo[2.2.1]hept-5-ene, etc. may be mentioned.

As the cyclic olefin which has an acid anhydride group, for example, tetracyclo[6.2.1.1^{3,6}.0^{2,7}]dodec-9-ene-4,5-dicarboxylic anhydride, bicyclo[2.2.1]hept-5-ene-2,3-dicarboxylic anhydride, 2-carboxymethyl-2-hydroxycarbonylbicyclo[2.2.1]hept-5-ene anhydride, etc. may be mentioned.

As the cyclic olefin which has a halogen atom, for example, 2-chlorobicyclo[2.2.1]hept-5-ene, 2-chloromethylbicyclo[2.2.1]hept-5-ene, 2-(chlorophenyl)bicyclo[2.2.1]hept-5-ene, 4-chlorotetracyclo [6.2.1.1^{3,6}.0^{2,7}] dodec-9-ene, 4-methyl-4-chlorotetracyclo[6.2.1.1^{3,6}.0^{2,7}]dodec-9-ene, etc. may be mentioned.

These monomers (b1) may respectively be used alone or may be used as two types or more combined.

As the cyclic olefin monomer which does not have a polar group (b2), bicyclo[2.2.1]hept-2-ene (also called "norbornene"), 5-ethylbicyclo[2.2.1]hept-2-ene, 5-butyl-bicyclo[2.2.1]hept-2-ene, 5-ethylidene-bicyclo[2.2.1]hept-2-ene, 5-methylidene-bicyclo[2.2.1]hept-2-ene, 5-vinyl-bicyclo[2.2.1]hept-2-ene, tricyclo[5.2.1.0^{2,6}]deca-3,8-diene (common name: dicyclopentadiene), tetracyclo [10.2.1.0^{2,11}.0^{4,9}] pentadec-4,6,8,13-tetraene, tetracyclo [6.2.1.1^{3,6}.0^{2,7}] dodec-4-ene (also called "tetracyclododecene"), 9-methyl-tetracyclo [6.2.1.1^{3,6}.0^{2,7}] dodec-4-ene, 9-ethyl-tetracyclo[6.2.1.1^{3,6}.0^{2,7}]dodec-4-ene, 9-methylidene-tetracyclo[6.2.1.1^{3,6}.0^{2,7}]dodec-4-ene, 9-ethylidene-tetracyclo[6.2.1.1^{3,6}.0^{2,7}]dodec-4-ene, 9-vinyl-tetracyclo[6.2.1.1^{3,6}.0^{2,7}]dodec-4-ene, 9-propenyl-tetracyclo[6.2.1.1^{3,6}.0^{2,7}]dodec-4-ene, pentacyclo[9.2.1.1^{3,9}.0^{2,10}.0^{4,8}]pentadeca-5, 12-diene, cyclobutene, cyclopentene, cyclopentadiene, cyclohexene, cycloheptene, cyclooctene, cyclooctadiene, indene, 3a,5,6,7a-tetrahydro-4,7-methano-1H-indene, 9-phenyl-tetracyclo[6.2.1.1^{3,6}.0^{2,7}]dodec-4-ene, tetracyclo[9.2.1.0^{2,10}.0^{3,8}]tetradec-3,5,7,12-tetraene, pentacyclo[9.2.1.1^{3,9}.0^{2,10}.0^{4,8}]pentadec-12-ene, etc. may be mentioned.

These monomers (b2) may respectively be used alone or may be used as two types or more combined.

As specific examples of the monomer other than a cyclic olefin (b3), ethylene; propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene, 1-eicosene, and other C₂ to C₂₀ α-olefins; 1,4-hexadiene, 1,5-hexadiene, 4-methyl-1,4-hexadiene, 5-methyl-1,4-hexadiene, 1,7-octadiene, and other nonconjugated dienes and their derivatives; etc. may be mentioned. Among these as well, α-olefin is preferable.

These monomers (b3) may respectively be used alone or may be used as two types or more combined.

Among these monomers (b1) to (b3) as well, from the viewpoint of the effect of the present invention becoming more remarkable, a cyclic olefin monomer which has a polar group other than a protonic polar group (b1) is preferable, while a cyclic olefin which has an N-substituted imide group is particularly preferable.

In the cyclic olefin polymer (A), the ratio of content of units of the copolymerizable monomer (b) is preferably 10 to 90 mol% with respect to the total monomer units, more preferably 20 to 80 mol%, still more preferably 30 to 70 mol%. If the content of the units of the monomer (a) is too small, the cyclic olefin polymer (A1) is liable to become insufficient in the solubility in a polar solvent. If the content of the units of the monomer (a) is too large, radiation-sensitivity is liable to be insufficient or dissolution residue is liable to be generated when developing.

Note that, in the present invention, it is also possible to introduce a protonic group in a cyclic olefin-based polymer which does not have a protonic polar group utilizing a known modifying agent so as to obtain the cyclic olefin polymer (A).

The polymer which does not have a protonic polar group can be obtained by polymerizing at least one of the above-mentioned monomers (b1) and (b2) and, in accordance with need, a monomer (b3) in any combination.

As a modifying agent for introduction of a protonic polar group, usually a compound which has a protonic polar group and a reactive carbon-carbon unsaturated bond in a single molecule is used.

As specific examples of this compound, acrylic acid, methacrylic acid, angelic acid, tiglic acid, oleic acid, elaidic acid, erucic acid, brassidic acid, maleic acid, fumaric acid, citraconic acid, mesaconic acid, itaconic acid, atropic acid, cinnamic acid, or other unsaturated carboxylic acid; allyl alcohol, methylvinyl methanol, crotyl alcohol, methacryl alcohol, 1-phenylethen-1-ol, 2-propen-1-ol, 3-buten-1-ol, 3-buten-2-ol, 3-methyl-3-buten-1-ol, 3-methyl-2-buten-1-ol, 2-methyl-3-buten-2-ol, 2-methyl-3-buten-1-ol, 4-penten-1-ol, 4-methyl-4-penten-1-ol, 2-hexen-1-ol, or other unsaturated alcohol; etc. may be mentioned.

The modification reaction of a polymer in which these modifying agents are used may be performed in accordance with an ordinary method and is usually performed in the presence of a radical generator.

Note that, the cyclic olefin polymer (A) used in the present invention may be a ring-opened polymer obtained by ring-opening polymerization of the above-mentioned monomers or may be an addition polymer obtained by addition polymerization of the above-mentioned monomers, but from the viewpoint of the effect of the present invention becoming more remarkable, a ring-opened polymer is preferable.

A ring-opened polymer can be produced by ring-opening methathesis polymerization of a cyclic olefin monomer which has a protonic polar group (a) and a copolymerizable monomer (b) used according to need in the presence of a methathesis reaction catalyst. As the method of production, for example, the method described in International Publication No. 2010/110323A, [0039] to [0079], etc. can be used.

Further, when the cyclic olefin polymer (A) used in the present invention is a ring-opened polymer, it is preferable to further perform a hydrogenation reaction and obtain a hydrogenated product in which the carbon-carbon double bonds which are contained in the main chain are hydrogenated. When the cyclic olefin polymer (A) is a hydrogenated product, the ratio of the hydrogenated carbon-carbon double bonds (hydrogenation rate) is usually 50% or more. From the viewpoint of the heat resistance, 70% or more is preferable, 90% or more is more preferable, and 95% or more is furthermore preferable.

The cyclic olefin polymer (A) used in the present invention has a weight average molecular weight (Mw) of usually 1,000 to 1,000,000, preferably 1,500 to 100,000, more preferably 2,000 to 30,000 in range.

Further, the cyclic olefin polymer (A) has a molecular weight distribution of a weight average molecular weight/number average molecular weight (Mw/Mn) ratio of usually 4 or less, preferably 3 or less, more preferably 2.5 or less.

The weight average molecular weight (Mw) and molecular weight distribution (Mw/Mn) of the cyclic olefin polymer (A) are values which are found by gel permeation chromatography (GPC) using a solvent such as tetrahydrofuran as an eluent and as values converted to polystyrene.

(Bifunctional Epoxy Compound (B) Represented by General Formula (1))

The radiation-sensitive resin composition of the present invention contains, in addition to the cyclic olefin polymer (A), a bifunctional epoxy compound (B) represented by the following general formula (1) (below, suitably abbreviated as "bifunctional chain epoxy compound (B)").

The bifunctional chain epoxy compound (B) acts as a cross-linking agent of the cyclic olefin polymer (A) in the radiation-sensitive resin composition of the present invention and exhibits the effect of lowering the elastic modulus in the case made into a resin film due to the linear chain structure. Due to this, it is possible to efficiently and effectively prevent the occurrence of warping of the resin film obtained using the radiation-sensitive resin composition of the present invention.

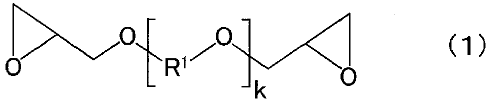

In the general formula (1), R¹ is a linear chain or branched alkylene group having 1 to 15 carbon atoms, preferably a linear chain or branched alkylene group having 2 to 10 carbon atoms, more preferably a linear chain or branched alkylene group having 3 to 8 carbon atoms. Note that, R¹ may be either of a linear chain alkylene group or branched alkylene group, but from the viewpoint of a larger effect of lowering the elastic modulus, a linear chain alkylene group is preferable. Further "k" is an integer of 1 to 20, preferably an integer of 1 to 18, more preferably an integer of 2 to 15.

In the present invention, even among the compounds represented by the general formula (1), from the viewpoint of being able to lower more the elastic modulus of the resin film obtained using the radiation-sensitive resin composition of the present invention, it is possible to suitably use the compound represented by the following general formula (4) (polytetramethylene glycol glycidyl ether):

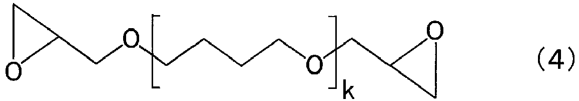

In the above general formula (4), "k" is an integer of 1 to 20, preferably an integer of 1 to 18, more preferably an integer of 2 to 15.

As the bifunctional chain epoxy compound (B), from the viewpoint of being able to lower more the elastic modulus of the resin film obtained using the radiation-sensitive resin composition of the present invention, one with an epoxy equivalent of 100 to 1000 in range is preferable. More preferably it is 200 to 800, still more preferably 300 to 600. Note that, the epoxy equivalent of the bifunctional chain epoxy compound (B), for example, can be measured in accordance with JIS K 7236 "Method of Finding Epoxy Equivalent of Epoxy Resin".

Further, as the bifunctional chain epoxy compound (B), from the viewpoint of being able to lower more the elastic modulus of the resin film obtained using the radiation-sensitive resin composition of the present invention, one with a softening point of 40°C or less is preferable, while one of 25°C or less is particularly preferable. That is, as the bifunctional chain epoxy compound (B), one which is liquid at ordinary temperature (25°C) is preferable. The softening point of the bifunctional chain epoxy compound (B) can, for example, be measured in accordance with JIS K 2207.

In the radiation-sensitive resin composition of the present invention, the content of the bifunctional chain epoxy compound (B) is preferably 8 to 150 parts by weight with respect to 100 parts by weight of the cyclic olefin polymer (A). Note that, from the viewpoint of making the resin film obtained using the radiation-sensitive resin composition of the present invention one which is low in elastic modulus and excellent in thermal shock resistance and developability, the content of the bifunctional chain epoxy compound (B) may be made the above range, but from the viewpoint of enhancing more the effect of lowering the elastic modulus and the effect of improvement of the thermal shock resistance, the content of the bifunctional chain epoxy compound (B) is more preferably made 20 parts by weight or more with respect to 100 parts by weight of the cyclic olefin polymer (A). Furthermore, from the viewpoint of improving the solder heat resistance of the resin film obtained using the radiation-sensitive resin composition of the present invention, the content of the bifunctional chain epoxy compound (B) is preferably 100 parts by weight or less with respect to 100 parts by weight of the cyclic olefin polymer (A), more preferably 70 parts by weight or less.

### (Radiation-Sensitive Compound (C))

Further the radiation-sensitive resin composition of the present invention contains a radiation-sensitive compound (C) in addition to the cyclic olefin polymer (A) and bifunctional chain epoxy compound (B). The radiation-sensitive compound (C) is a compound able to cause a chemical reaction by irradiation of radiation such as ultraviolet rays or electron beams.

According to the present invention, by jointly using a radiation-sensitive compound (C) in addition to the cyclic olefin polymer (A) and bifunctional chain epoxy compound (B), due to the action of the radiation-sensitive compound (C), it is possible to improve the mutual solubility of the cyclic olefin polymer (A) and bifunctional chain epoxy compound (B). Due to this, it is possible to suitably obtain the effect of addition of the bifunctional chain epoxy compound (B), that is, the effect of lowering of the elastic modulus. Furthermore, due to this, the resin film obtained using the radiation-sensitive resin composition of the present invention can be made one with a low elastic modulus, suppressed in occurrence of warping due to the same, and excellent in thermal shock resistance and developability.

In the present invention, the radiation-sensitive compound (C) is preferably one which enables control of the alkali solubility of a resin film formed from the radiation-sensitive resin composition, particularly preferably a photoacid generator is used. As such a radiation-sensitive compound (C), for example, an azide compound such as an acetophenone compound, triaryl sulfonium salt, and quinone diazide compound may be mentioned, an azide compound is preferable, a quinone diazide compound is more preferable.

As the quinone diazide compound, for example, an ester compound of a quinone diazide sulfonic acid halide and a compound having a phenolic hydroxyl group may be used. As specific examples of a quinone diazide sulfonic acid halide, 1,2-naphthoquinone diazide-5-sulfonic acid chloride, 1,2-naphtoquinone diazide-4-sulfonic acid chloride, 1,2-benzoquinone diazide-5-sulfonic acid chloride, etc. may be mentioned. As representative examples of a compound having a phenolic hydroxyl group, 1,1,3-tris(2,5-dimethyl-4-hydroxyphenyl)-3-phenylpropane, 4,4'-[1-[4-[1-[4-hydroxyphenyl]-1-methylethyl]phenyl]ethylidene]bisphenol, etc. may be mentioned. As compounds having a phenolic hydroxyl group other than these, 2,3,4-trihydroxybenzophenone, 2,3,4,4'-tetrahydroxybenzophenone, 2-bis(4-hydroxyphenyl)propane, tris(4-hydroxyphenyl)methane, 1,1,1-tris(4-hydroxy-3-methylphenyl)ethane, 1,1,2,2-tetrakis(4-hydroxyphenyl)ethane, an oligomer of a novolac resin, an oligomer obtained by copolymerization of a compound having one or more phenolic hydroxyl groups and dicyclopentadiene, etc. may be mentioned.

Further, as the photoacid generator, other than a quinine diazide compound, a known one such as an onium salt, halogenated organic compound, α,α'-bis(sulfonyl)diazomethane-based compound, α-carbonyl-α'-sulfonyldiazo-methane-based compound, sulfone compound, organic acid ester compound, organic acid amide compound, and an organic acid imide compound can be used.

These radiation-sensitive compounds may be used respectively alone or as two or more types combined.

In the radiation-sensitive resin composition of the present invention, the content of the radiation-sensitive compound (C) is preferably 10 to 100 parts by weight with respect to 100 parts by weight of the cyclic olefin polymer (A), more preferably 15 to 70 parts by weight, still more preferably 25 to 50 parts by weight. By making the content of the radiation-sensitive compound (C) this range, it is possible to improve the pattern formability of the resin film obtained using the radiation-sensitive resin composition of the present invention.

### (Other Compounding Agents)

Further, the radiation-sensitive resin composition of the present invention may further contain a cross-linking agent other than the above-mentioned bifunctional chain epoxy compound (B). As such a cross-linking agent, one forming a cross-linked structure between molecules of the cross-linking agent by heating or one reacting with the cyclic olefin polymer (A) and forming a cross-linked structure between resin molecules may be used, but, for example, an epoxy group-containing cross-linking agent other than a bifunctional chain epoxy compound (B), an oxetane group-containing cross-linking agent, an isocyanate group-containing cross-linking agent, a block isocyanate group-containing cross-linking agent, an oxazoline group-containing cross-linking agent, a maleimide group-containing cross-linking agent, a (meth)acrylate group-containing cross-linking agent, a compound containing two or more alkoxymethyl groups or methylol groups in its molecule, etc. may be mentioned. Among these as well, a compound including two or more alkoxymethyl groups or methylol groups in its molecule is preferable. By further including a cross-linking agent other than the bifunctional chain epoxy compound (B), it is possible to further raise the thermal shock resistance of the obtained resin film.

As specific examples of the epoxy group-containing cross-linking agent other than a bifunctional chain epoxy compound (B), for example, an epoxy compound having an alicyclic structure such as an epoxy compound having dicyclopentadiene as a skeleton (product name "HP-7200", made by DIC), a 1,2-epoxy-4-(2-oxiranyl)cyclohexane adduct of 2,2-bis(hydroxymethyl)1-butanol (15-functional alicyclic epoxy resin having a cyclohexane skeleton and terminal epoxy group, product name "EHPE3150", made by Daicel Chemical Industries), an epoxylated 3-cyclohexene-1,2-dicarboxylic acid bis(3-cyclohexenylmethyl)-modified ε-caprolactone (aliphatic cyclic tri-functional epoxy resin, product name "Epolide GT301", made by Daicel Chemical Industries), epoxylated butanetetracarboxylic acid tetrakis(3-cyclohexenylmethyl)-modified ε-caprolactone (aliphatic cyclic tetrafunctional epoxy resin, product name "Epolide GT401", made by Daicel Chemical Industries), 3,4-epoxycyclohexenylmethyl-3',4'-epoxycyclohexenecarboxylate (product names "Celloxide 2021" and "Celloxide 2021P", made by Daicel Chemical Industries), ε-caprolactone-modified 3',4'-epoxycyclohexylmethyl-3,4-epoxycyclohexane carboxylate (product name "Celloxide 2081", made by Daicel Chemical Industries), and 1,2:8,9-diepoxylimonene (product name "Celloxide 3000", made by Daicel Chemical Industries);
an epoxy compound not having an alicyclic structure such as a bisphenol A type epoxy compound (product names "jER 825", "jER 827", "jER 828", and "jER YL980", made by Mitsubishi Chemical and product names "EPICLON 840" and "EPICLON 850", made by DIC), a bisphenol F type epoxy compound (product names "jER 806", "jER 807", and "jER YL983U", made by Mitsubishi Chemical, and product names "EPICLON 830" and "EPICLON 835", made by DIC), hydrated bisphenol A type epoxy compound (product names "jER YX8000" and "jER YX8034", made by Mitsubishi Chemical, product name "ST-3000", made by Nippon Steel & Sumitomo Metal, product name "Rikaresin HBE-100", made by New Japan Chemical, and product name "Epolite 4000", made by Kyoei Kagaku Kogyou), a long chain bisphenol A type epoxy resin (product names "EXA-4816", "EXA-4850-150", and "EXA-4850-1000", made by DIC), EO-modified bisphenol A type epoxy compound (product names "Adeka Resin EP-4000L" and "Adeka Resin EP-4010L", made by Adeka), phenol novolac type polyfunctional epoxy compound (product name "jER 152", made by Mitsubishi Chemical), a polyfunctional epoxy compound having a naphthalene structure such as 1,6-bis(2,3-epoxy propan-1-yloxy)naphthalene (product name "HP-4032D", made by DIC), dicyclopentadiene dimethanol diglycidyl ether (product names "Adeka Resin EP-4000L" and "Adeka Resin EP-4088L", made by Adeka), glycidyl amine type epoxy resin (product name "product name "jER630", made by Mitsubishi Chemical, product names "TETRAD-C" and "TETRAD-X", made by Mitsubishi Gas Chemical), chain type alkylpolyfunctional epoxy compound (product name "SR-TMP", made by Sakamoto Yakuhin Kogyo), polyfunctional epoxy polybutadiene (product name "Epolide PB3600", made by Daicel Chemical Industries, product name "Epolide PB4700", made by Daicel Chemical Industries), a glycidyl polyether compound of glycerin (product name "SR-GLG", made by Sakamoto Yakuhin Kogyo), a diglycerin polyglycidyl ether compound (product name "SR-DGE", made by Sakamoto Yakuhin Kogyo), and polyglycerin polyglycidyl ether compound (product name "SR-4GL", made by Sakamoto Yakuhin Kogyo); etc. may be mentioned.

Among these epoxy group-containing cross-linking agents other than a bifunctional chain epoxy compound (B), an epoxy compound having an alicyclic structure, that is, alicyclic epoxy compound, is preferable. By using the epoxy compound having an alicyclic structure, the effect of improving the thermal shock resistance of the obtained resin film can be more remarkable.

The compound containing two or more alkoxymethyl groups in its molecule is not particularly limited so long as a compound having two or more alkoxymethyl groups. As a phenol compound having two or more alkoxymethyl groups directly bonded to an aromatic ring, for example, dimethoxymethyl substituted phenol compound such as 2,6-dimethoxymethyl-4-t-butyl phenol and 2,6-dimethoxymethyl-p-cresol, tetramethoxymethyl substituted biphenyl compound such as 3,3',5,5'-tetramethoxymethyl-4,4'-dihydroxybiphenyl (for example, product name "TMOM-BP", made by Honshu Chemical Industry) and 1,1-bis[3,5-di(methoxymethyl)-4-hydroxyphenyl]-1-phenylethane, hexamethoxymethyl substituted triphenyl compound such as 4,4',4"-(ethylidene)trisphenol and other hexamethoxymethyl substituted compound (for example, product name "HMOM-TPHAP-GB", made by Honshu Chemical Industry), etc. may be mentioned.

The compound including two or more methylol groups in its molecule is not particularly limited so long as a compound including two or more methylol groups. As a phenol compound having two or more methylol groups directly bonded to an aromatic ring, 2,4-2,4-dihydroxymethyl-6-methyl phenol, 2,6-bis(hydroxymethyl)-p-cresol, 4-tertiary-2,6-bis(hydroxymethyl)phenol, bis(2-hydroxy-3-hydroxymethyl-5-methylphenyl)methane (product name "DM-BIPC-F", made by Asahi Yukizai), bis(4-hydroxy-3-hydroxymethyl-5-methylphenyl)methane (product name "DM-BIOC-F", made by Asahi Yukizai), 2,2-bis(4-hydroxy-3,5-dihydroxymethylphenyl)propane (product name "TM-BIP-A", made by Asahi Yukizai), etc. may be mentioned.

As a melamine compound with an amino group substituted by two or more alkoxymethyl groups used as a compound containing two or more alkoxymethyl groups in its molecule, for example, N,N'-dimethoxymethyl melamine, N,N',N"-trimethoxymethyl melamine, N,N,N',N" - tetramethoxymethyl melamine, N,N,N',N',N''-pentamethoxymethyl melamine, N,N,N',N',N",N"-hexamethoxymethyl melamine (for example, "Nikalac MW-390LM" and "Nikalac MW-100LM", made by Sanwa Chemical), or polymers of the same etc. may be mentioned.

As a urea compound substituted by two or more alkoxymethyl groups used as a compound containing two or more alkoxymethyl groups in its molecule, "Nikalac MX270", made by Sanwa Chemical, "Nikalac MX280", made by Sanwa Chemical, "Nikalac MX290", made by Sanwa Chemical, etc. may be mentioned.

The compound containing two or more alkoxymethyl groups or methylol groups in its molecule can be used as single types alone or in combinations of two or more types.

Among these as well, from the viewpoint of the high reactivity, N,N,N',N',N",N"-hexamethoxymethyl melamine is preferable.

In the radiation-sensitive resin composition of the present invention, the content of the cross-linking agent other than the bifunctional chain epoxy compound (B) is preferably 1 to 80 parts by weight with respect to 100 parts by weight of the cyclic olefin polymer (A), more preferably 5 to 75 parts by weight, still more preferably 10 to 70 parts by weight. If making the content of the cross-linking agent other than the bifunctional chain epoxy compound (B) this range, it is possible to further raise the thermal shock resistance of the resin film obtained using the radiation-sensitive resin composition of the present invention.

Further, the radiation-sensitive resin composition of the present invention may further contain a silane coupling agent in addition to the above-mentioned constituents. The silane coupling agent is used for better improving the adhesion of the resin film obtained using the radiation-sensitive resin composition of the present invention.

The silane coupling agent is not particularly limited, but, for example, one having a reactive functional group such as an amino group, carboxyl group, methacryloyl group, isocyanate group, and epoxy group may be mentioned.

As specific examples of the silane coupling agent, 3-aminopropyltrimethoxysilane, 3-aminopropyltriethoxysilane, N-2-(aminoethyl)-3-aminopropyltrimethoxysilane, N-phenyl-3-aminopropyltrimethoxysilane, trimethoxysilyl benzoic acid, γ-methacryloxypropyltrimethoxysilane, γ-methacryloxy-propyltriethoxysilane, γ-isocyanatepropyltrimethoxysilane, γ-isocyanatepropyltriethoxysilane, γ-glycidoxypropyltrimethoxysilane, γ-glycidoxypropyltriethoxysilane, β-(3,4-epoxycyclohexyl)ethyltrimethoxysilane, β-(3,4-epoxycyclohexyl)ethyl-triethoxysilane, etc. may be mentioned. These silane coupling agents may be used respectively alone or as two or more types combined. Among these as well, γ-glycidoxypropyltrimethoxysilane, N-phenyl-3-aminopropyltrimethoxy-silane are preferable, while γ-glycidoxypropyltrimethoxysilane is more preferable.

In the radiation-sensitive resin composition of the present invention, the content of the silane coupling agent is preferably 0.01 to 100 parts by weight with respect to 100 parts by weight of the cyclic olefin polymer (A), more preferably 0.1 to 50 parts by weight, still more preferably 0.5 to 20 parts by weight. By making the content of the silane coupling agent the above range, it is possible to further raise the effect of addition.

Further, the radiation-sensitive resin composition of the present invention may further contain a solvent. The solvent is not particularly limited, but one known as a solvent of a resin composition, for example, linear chain ketones such as acetone, methyethylketone, cyclopentanone, 2-hexanone, 3-hexanone, 2-heptanone, 3-heptanone, 4-heptanone, 2-octanone, 3-octanone, and 4-octanone; alcohols such as n-propyl alcohol, isopropyl alcohol, and n-butyl alcohol; cyclohexanol; ethers such as ethylene glycol dimethyl ether, ethylene glycol diethyl ether, and dioxane; alcohol ethers such as ethylene glycol monomethyl ether and ethylene glycol monoethyl ether; esters such as propyl formate, butyl formate, propyl acetate, butyl acetate, methyl propionate, ethyl propionate, methyl butyrate, ethyl butyrate, methyl lactate, and ethyl lactate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether; diethylene glycols such as diethylene glycol monomethyl ether, diethylene glycol monoethyl ether, diethylene glycol dimethyl ether, diethylene glycol diethyl ether, and diethylene glycol methyethyl ether; saturated γ-lactones such as γ-butyrolactone, γ-valerolactone, γ-caprolactone, and γ-caprylolactone; halogenated hydrocarbons such as trichloroethylene; aromatic hydrocarbons such as toluene and xylene; polar solvents such as dimethyl acetoamide, dimethyl formamide, and N-methyl acetoamide etc. may be mentioned. These solvents may be used alone or as two types or more combined. The content of the solvent is preferably 10 to 10000 parts by weight with respect to 100 parts by weight of the cyclic olefin polymer (A), more preferably 50 to 5000 parts by weight, still more preferably 100 to 1000 parts by weight in range. Note that, if making the radiation-sensitive resin composition of the present invention contain a solvent, the solvent is usually removed after formation of the resin film.

Further, the resin composition of the present invention may contain, if a range where the effect of the present invention is not obstructed, as desired, another compounding agent such as a compound having an acidic group or a thermal latent acidic group, a surfactant, an antioxidant, sensitizer, photostabilizer, defoamer, pigment, dye, and filler. Among these, for example, a compound having an acidic group or a thermal latent acidic group described in Japanese Patent Publication No. 22014-29766A etc. may be used. Further, the surfactant, sensitizer, and photostabilizer used may be ones described in Japanese Patent Publication No. 2011-75609A etc.

The method of preparation of the radiation-sensitive resin composition of the present invention is not particularly limited. The constituents forming the radiation-sensitive resin composition may be mixed by a known method.

The method of mixing is not particularly limited, but it is preferable to dissolve or disperse the constituents forming the radiation-sensitive resin composition in a solvent and mix the obtained solution or dispersion. Due to this, the radiation-sensitive resin composition can be obtained in the form of a solution or dispersion.

The method of dissolving or dispersing the constituents forming the radiation-sensitive resin composition in the solvent may be based on an ordinary method. Specifically, it is possible to use stirring using a stirrer and magnetic stirrer, a high speed homogenizer, a disperser, a planetary stirrer, a twin-screw stirrer, a ball mill, a triple roll, etc. Further, after dissolving or dispersing the constituents in the solvent, for example, the mixture may be filtered using a pore size 0.5 µm or so filter.

The solids concentration of the radiation-sensitive resin composition of the present invention is usually 1 to 70 wt%, preferably 5 to 60 wt%, more preferably 10 to 50 wt%. If the solids concentration is in this range, the stability of dissolution, the coatability, the uniformity and flatness of the resin film formed, etc. can be balanced to a high degree.

### (Electronic Device)

The electronic device of the present invention has a resin film comprised of the above-mentioned radiation-sensitive resin composition of the present invention.

The electronic device of the present invention is not particularly limited, but the resin film comprised of the radiation-sensitive resin composition of the present invention is low in elastic modulus, suppressed in occurrence of warping due to this, and excellent in thermal shock resistance and developability, so an electronic device produced by the wafer level packaging technology is suitable. In particular, the resin film comprised of the radiation-sensitive resin composition of the present invention is more suitably one used as one forming an interlayer insulating film for insulating among interfaces arranged in layers in an electronic device produced by wafer level packaging technology.

In the electronic device of the present invention, the method for forming the resin film is not particularly limited. For example, a method such as the coating method or film lamination method may be used.

The coating method is, for example, the method of coating the resin composition, then heating it to dry to remove the solvent. As the method of coating the resin composition, for example, various methods such as the spray method, spin coat method, roll coat method, die coat method, doctor blade method, rotating coat method, slit coat method, bar coat method, screen print method, and inject method can be employed. The heating and drying conditions differ according to the type and ratio of the constituents, but are usually 30 to 150°C, preferably 60 to 120°C, usually for 0.5 to 90 minutes, preferably 1 to 60 minutes, more preferably 1 to 30 minutes.

The film lamination method is a method comprising coating a radiation-sensitive resin composition on a substrate for forming a B-stage film such as a resin film or metal film, then heating and drying it to remove the solvent to obtain the B-stage film, then laminating this B-stage film. The heating and drying conditions may be suitably selected in accordance with the types and ratios of content of the constituents, but the heating temperature is usually 30 to 150°C and the heating time is usually 0.5 to 90 minutes. The film lamination may be performed by using a press bonding machine such as a press laminator, press, vacuum laminator, vacuum press, and roll laminator.

The thickness of the resin film is not particularly limited and may be suitably set in accordance with the application, but is preferably 0.1 to 100 µm, more preferably 0.5 to 50 µm, furthermore preferably 0.5 to 30 µm.

Next, the thus formed resin film was patterned by a predetermined pattern. As the method of patterning the resin film, for example, the method of using the radiation-sensitive resin composition of the present invention to form a resin film before patterning, irradiating the resin film before patterning with activating radiation to form a latent pattern, then bringing the developing solution into contact with the resin film having the latent pattern to bring out the patterns etc. may be mentioned.

The activating radiation is not particularly limited so long as able to activate the radiation-sensitive compound (C) contained in the radiation-sensitive resin composition and change the alkali solubility of the radiation-sensitive resin composition containing the radiation-sensitive compound (C). Specifically, single wavelength ultraviolet rays such as ultraviolet rays, g-rays, and i-rays; light beams such as KrF excimer light and ArF excimer laser light; particle beams such as electron beams; etc. can be used. As the method of selectively irradiating these activating radiation in a pattern to form a latent pattern, an ordinary method may be used. For example, the method of using a reduced projection exposure apparatus etc. to irradiate light beams such as ultraviolet rays, g-rays, i-rays, KrF excimer laser light, and ArF excimer laser light through a desired master pattern or the method of lithography using particle beams of electron beams etc. may be used. If using light beams as the activating radiation, single wavelength light or mixed wavelength light may be used. The irradiating conditions are suitably selected in accordance with the activating radiation used, but, for example, if using light beams of a wavelength of 200 to 450 nm, the amount of irradiation is usually 10 to 5,000 mJ/cm², preferably 50 to 1,500 mJ/cm² in range, and is determined in accordance with the irradiation time and luminance. After irradiating the activating radiation in this way, in accordance with need, the resin film is heat treated at a temperature of 60 to 130°C or so for 1 to 2 minutes or so.

Next, the latent pattern formed on the resin film before patterning is developed to manifest it. As the developing solution, usually an aqueous solution of an alkali compound is used. As the alkali compound, for example, an alkali metal salt, amine, or ammonium salt may be used. The alkali compound may be an inorganic compound or an organic compound. As specific examples of these compounds, alkali metal salts such as sodium hydroxide, potassium hydroxide, sodium carbonate, sodium silicate, and sodium metasilicate; ammonia water; primary amines such as ethylamine and n-propylamine; secondary amines such as diethylamine and di-n-propylamine; tertiary amines such as triethylamine and methyldiethylamine; quaternary ammonium salts such as tetramethyl ammonium hydroxide, tetraethyl ammonium hydroxide, tetrabutyl ammonium hydroxide, and choline; alcohol amines such as dimethyl ethanolamine and triethanol amine; cyclic amines such as pyrrole, piperidine, 1,8-diazabicyclo[5.4.0]undec-7-ene, 1,5-diasabicyclo[4.3.0]non-5-ene, and N-methylpyrrolidone; etc. may be mentioned. These alkali compounds may be used respectively alone or as two or more types combined.

As the aqueous medium of the alkali aqueous solution, water or an aqueous organic solvent such as methanol or ethanol may be used. The alkali aqueous solution may be one including a surfactant etc. added in a suitable amount.

As the method of bringing the developing solution into contact with the resin film having the latent pattern, for example, a method such as the puddle method, spray method, and dipping method is used. The development is usually performed at 0 to 100°C, preferably 5 to 55°C, more preferably 10 to 30°C in range usually for 30 to 180 seconds in range.

The resin film formed with a pattern targeted in this way can be rinsed by a rinse solution so as to remove the development residue in accordance with need. After the rinsing, the remaining rinse solution is removed by compressed air or compressed nitrogen.

Furthermore, in accordance with need, to deactivate the radiation-sensitive compound (C) contained in the radiation-sensitive resin composition, the entire surface of the electronic device can be irradiated with activating radiation. For irradiating the activated radiation, the method illustrated for formation of the latent pattern can be utilized. At the same time as irradiation or after irradiation, the resin film may be heated. As the heating method, for example, the method of heating the electronic device in an autoclave or oven may be mentioned. The temperature is usually 80 to 300°C, preferably 100 to 200°C in range.

Next, the thus formed resin film was patterned, then subjected to a cross-linking reaction to cause the resin film to cure. Such cross-linking may be performed by a method suitably selected in accordance with the type of the bifunctional chain epoxy compound (B) included in the radiation-sensitive resin composition or the cross-linking agent other than the bifunctional chain epoxy compound (B) used according to need, but is usually performed by heating. The heating can be performed by the method of, for example, using a hot plate, oven, etc. The heating temperature is usually 150 to 250°C, while the heating time is suitably selected by the area or thickness of the resin film, the equipment used, etc. For example, when using a hot plate, it is 5 to 120 minutes, while when using an oven, it is usually 30 to 150 minutes in range. The heating may be performed, as necessary, in an inert gas atmosphere. As the inert gas, one which does not contain oxygen and which does not cause the resin film to oxidize may be used. For example, nitrogen, argon, helium, neon, xenon, krypton, etc. may be mentioned. Among these as well, nitrogen and argon are preferable. In particular, nitrogen is preferable. In particular, an inert gas with an oxygen content of 0.1 vol% or less, preferably 0.01 vol% or less, in particular nitrogen, is suitable. These inert gases may be used respectively alone or as two or more types combined.

In this way, it is possible to produce an electronic device provided with a patterned resin film.

### EXAMPLES

Below, examples and comparative examples will be given to explain the present invention more specifically. In the examples, the "parts" are based on weight so long as not indicated otherwise.

Note that the definitions and methods of evaluation of the characteristics are as follows:

### <Elastic Modulus>

A sputtering apparatus was used to form an aluminum thin film of a film thickness of 100 nm on a silicon wafer. On this, a radiation-sensitive resin composition prepared in each of the examples and comparative examples was spin coated, then the composition was heated using a hot plate at 120°C for 2 minutes then made to cure in a nitrogen atmosphere at 230°C for 60 minutes to form a resin film of a film thickness of 10 µm and obtain a laminate. Furthermore, the obtained laminate was cut into a predetermined size, then the aluminum thin film was dissolved by a 0.1 mol/liter hydrochloric acid aqueous solution and peeled off. The peeled off film was dried to obtain a resin film. Furthermore, the obtained resin film was cut into a test piece (10 mm×50 mm) and the test piece was subjected to a tensile test by the following procedure to measure the tensile elastic modulus. That is, an autograph (made by Shimadzu Corporation, AGS-5kNG) was used and a tensile test was performed in conditions of a distance between chucks of 20 mm, a tensile rate of 10 mm/min, and a measurement temperature of 23°C to measure the tensile elastic modulus (GPa) of a test piece. Note that, along with the two characteristics, five test pieces were cut out from each of the resin films and the average value of the measurement values of the test pieces was evaluated by the following criteria. Note that, the lower the tensile elastic modulus, the more the occurrence of warping after curing can be suppressed, so this is preferred.
A: Tensile elastic modulus of less than 2 GPa
B: Tensile elastic modulus of 2 GPa to less than 2.2 GPa
C: Tensile elastic modulus of 2.2 GPa or more

### <Thermal Shock Resistance>

An evaluation board for thermal shock use comprised of a silicon wafer on which patterned copper interconnects are formed was spin coated with a radiation-sensitive resin composition in each of the examples and comparative examples, then was heated at 120°C for 2 minutes then made to cure in a nitrogen atmosphere at 230°C for 60 minutes to thereby form a resin film with a film thickness of 10 µm and obtain a sample for evaluation. Furthermore, the obtained sample for evaluation was evaluated by a thermal shock test using a thermal shock tester (made by Tabai Espec) for cycles each of -55°C/30 minutes and 150°C/30 minutes. The number of cycles until the resin film cracked was confirmed and the following criteria was used to evaluate the thermal shock resistance.
AA: No cracks occurred even after 2000 cycles
A: No cracks occurred after 1500 cycles, but cracks occurred before reaching 2000 cycles.
B: No cracks occurred after 1000 cycles, but cracks occurred before reaching 1500 cycles
C: Cracks occurred before reaching 1000 cycles

### <Developability>

A silicon wafer was spin coated with a radiation-sensitive resin composition prepared in each of the examples and comparative examples, then a hot plate was used to prebake it at 120°C for 2 minutes to form a resin film of thickness of 10 µm. Next, a high pressure mercury lamp emitting light of wavelengths of g-rays (436 nm), h-rays (405 nm), and i-rays (365 nm) was used to expose the film at 400 mJ/cm². Furthermore, the exposed sample was immersed in a 23°C 2.38% tetramethyl ammonium hydroxide aqueous solution (alkali development solution) for 3 minutes, then was rinsed by ultrapure water for 30 seconds. The surface condition of the sample after development was visually examined and evaluated for developability by the following criteria. Samples in which the resin film did not dissolve or where no blisters occurred can be judged excellent in developability as a positive type resin film and further are effectively suppressed in occurrence of residue at the time of development, so are preferable.
A: Resin film completely dissolved.
B: Resin film only partially dissolved.
C: Resin film was not dissolved at all or blistered.

### <Solder Heat Resistance>

A sputtering apparatus was used to form a copper film of a film thickness of 100 nm on a silicon wafer on which a 50 nm thickness titanium film. On this, a radiation-sensitive resin composition prepared in each of the examples and comparative examples was spin coated, then was heated at 120°C for 2 minutes then made to cure in a nitrogen atmosphere at 230°C for 60 minutes to thereby form a resin film of a film thickness of 10 µm to obtain a laminate. On the resin film of the laminate obtained in such a way, the sputtering method was used to form a copper foil film, then electroplating using an acidic aqueous solution containing copper sulfate as a plating bath was used to form a copper plating layer by a thickness of 10 µm, then heat treatment was performed at 180°C for 60 minutes to obtain a test piece. Furthermore, a test floating the obtained test piece in a solder bath of a solder temperature of 260°C for 10 seconds, allowing it to stand at room temperature for 30 seconds, then checking for any blisters of the copper plating layer was repeatedly performed until blisters of the copper plating layer were confirmed. The following criteria were followed to evaluate the solder heat resistance. The greater the number of times of repetition of the test until any blisters of the copper plating layer were confirmed, the more excellent the solder heat resistance can be evaluated as.
AA: Above test repeated 15 times, but even after 15th test, blisters of copper plating layer were not confirmed.
A: Number of repetitions of test until blisters of copper plating layer confirmed was 10 times to 14 times.
B: Number of repetitions of test until blisters of copper plating layer confirmed was 7 times to 9 times.
C: Number of repetitions of test until blisters of copper plating layer confirmed was less than 7 times.

### <<Synthesis Example 1>>

### <Preparation of Cyclic Olefin Polymer (A-1)>

100 parts of a monomer mixture comprised of 40 mol% of N-phenyl-bicyclo[2.2.1]hept-5-ene-2,3-dicarboxyimide (NBPI) and 60 mol% of 4-hydroxycarbonyltetracyclo[6.2.1.1^{3,6}.0^{2,7}]dodec-9-ene (TCDC), 2.0 parts of 1,5-hexadiene, 0.02 part of (1,3-dimesitylimidazolin-2-yldene)(tricyclohexylphosphine) benzylidene ruthenium dichloride (synthesized by method described in Org. Lett., vol. 1, p. 953, 1999), and 200 parts of diethylene glycol ethyl methyl ether were charged into a nitrogen-substituted glass pressure resistant reactor and stirred while causing a reaction at 80°C for 4 hours to obtain a polymerization reaction solution.

Furthermore, the obtained polymerization reaction solution was placed in an autoclave and stirred at 150°C at a hydrogen pressure of 4 MPa for 5 hours to perform a hydrogenation reaction to obtain a polymer solution including a cyclic olefin polymer (A-1). The polymerization conversion rate of the obtained cyclic olefin polymer (A-1) was 99.7%, the polystyrene conversion weight average molecular weight was 7,150, the polystyrene conversion number average molecular weight was 4,690, the molecular weight distribution was 1.52, and the hydrogenation rate was 99.7%. Further, the solids concentration of the obtained polymer solution of the cyclic olefin polymer (A-1) (low DMDG) was 34.4 wt%.

### <<Example 1>>

As a cyclic olefin polymer (A) having a protonic polar group, 291 parts of a polymer solution of the cyclic olefin polymer (A-1) obtained at Synthesis Example 1 (100 parts as cyclic olefin polymer (A-1)), 10 parts of a bifunctional chain epoxy compound (B) comprised of a bifunctional chain epoxy compound (product name "jER YX7400", made by Mitsubishi Chemical, epoxy equivalent: 440, softening point 25°C or less (liquid at ordinary temperature), compound of general formula (1) wherein R¹=-C₄H₈- and k=about 10), 30 parts of a radiation-sensitive compound (C) comprised of a condensate of 4,4'-[1-[4-[1-[4-hydroxyphenyl]-1-methyethyl]phenyl]ethylidene]bisphenol (1 mole) and 1,2-naphthoquinone diazide-5-sulfonic acid chloride (2.0 moles) (product name "TS200", made by Toyogosei), 10 parts of a cross-linking agent other than the bifunctional chain epoxy compound (B) comprised of N,N,N',N',N",N"-hexamethoxymethylmelamine (product name "Nikalac MW-100LM", made by Sanwa Chemical), 2 parts of a silane coupling agent comprised of γ-glycidoxypropyltrimethoxysilane (product name "Z6040", made by Toray Dow Corning), and 160 parts of a solvent comprised of diethylene glycol ethyl methyl ether were mixed and made to dissolve, then a polytetrafluoroethylene filter with a pore size of 0.45 µm was used to filter the mixture to prepare a radiation-sensitive resin composition.

Furthermore, the obtained radiation-sensitive resin composition was used to measure and evaluate the elastic modulus, thermal shock resistance, developability, and solder heat resistance. The results are shown in Table 1.

### <<Example 2>>

Except for changing the amount of the bifunctional chain epoxy compound (product name "jER YX7400", made by Mitsubishi Chemical) in Example 1 from 10 parts to 30 parts, the same procedure was followed as in Example 1 to prepare a radiation-sensitive resin composition and the same procedure was followed to measure and evaluate it. The results are shown in Table 1.

### <<Example 3>>

Except for changing the amount of the bifunctional chain epoxy compound (product name "jER YX7400", made by Mitsubishi Chemical) in Example 1 from 10 parts to 50 parts, the same procedure was followed as in Example 1 to prepare a radiation-sensitive resin composition and the same procedure was followed to measure and evaluate it. The results are shown in Table 1.

### <<Example 4>>

Except for changing the amount of the bifunctional chain epoxy compound (product name "jER YX7400", made by Mitsubishi Chemical) in Example 1 from 10 parts to 80 parts, the same procedure was followed as in Example 1 to prepare a radiation-sensitive resin composition and the same procedure was followed to measure and evaluate it. The results are shown in Table 1.

### <<Example 5>>

Except for further mixing in 20 parts of epoxylated butanetetracarboxylate tetrakis(3-cyclohexenylmethyl)-modified ε-caprolactone (product name "Epolide GT401", made by Daicel Chemical Industries, aliphatic cyclic 4-functional epoxy resin, epoxy equivalent: 220, liquid at ordinary temperature) as the cross-linking agent other than the bifunctional chain epoxy compound (B), in Example 3, the same procedure was followed as in Example 3 to prepare a radiation-sensitive resin composition and the same procedure was followed to measure and evaluate it. The results are shown in Table 1.

### <<Example 6>>

Except for changing the amount of bifunctional chain epoxy compound (product name "jER YX7400", made by Mitsubishi Chemical) in Example 1 from 10 parts to 130 parts, the same procedure was followed as in Example 1 to prepare a radiation-sensitive resin composition and the same procedure was followed to measure and evaluate it. The results are shown in Table 1.

### <<Comparative Example 1>>

Except for using, instead of 10 parts of bifunctional chain epoxy compound (product name "jER YX7400", made by Mitsubishi Chemical) in Example 1, 50 parts of an epoxy compound having a naphthalene skeleton (product name "Epiclon HP4700, made by DIC), the same procedure was followed as in Example 1 to prepare a radiation-sensitive resin composition and the same procedure was followed to measure and evaluate it. The results are shown in Table 1.

### <<Comparative Example 2>>

Except for using, instead of instead of 10 parts of bifunctional chain epoxy compound (product name "jER YX7400", made by Mitsubishi Chemical) in Example 1, 50 parts of long chain bisphenol A type epoxy resin (product name "EXA-4850-1000", made by DIC), the same procedure was followed as in Example 1 to prepare a radiation-sensitive resin composition and the same procedure was followed to measure and evaluate it. The results are shown in Table 1.

### <<Comparative Example 3>>

Except for using, instead of 10 parts of bifunctional chain epoxy compound (product name "jER YX7400", made by Mitsubishi Chemical) in Example 1, 50 parts of an epoxylated butane tetracarboxylic acid tetrakis(3-cyclohexenylmethyl)-modified ε-caprolactone (product name "Epolide GT401", made by Daicel Chemical Industries, aliphatic cyclic 4-functional epoxy resin, epoxy equivalent: 220, liquid at ordinary temperature), the same procedure was followed as in Example 1 to prepare a radiation-sensitive resin composition and the same procedure was followed to measure and evaluate it. The results are shown in Table 1.

### <<Comparative Example 4>>

Except for using instead of 291 parts of a polymer solution of the cyclic olefin polymer (A-1) obtained in Synthesis Example 1 (100 parts as cyclic olefin polymer (A-1)) in Example 3, 100 parts of a diethyleneglycol ethyl methyl ether solution of an acrylic polymer (product name "Maruka Lyncur CMM", made by Maruzen Petrochemical, copolymer of p-hydroxystyrene and methylmethacrylate) as the acrylic polymer, the same procedure was followed as in Example 3 to prepare a radiation-sensitive resin composition and the same procedure was followed to measure and evaluate it. The results are shown in Table 1.

### Table 1

**Table 1**

| | | | Examples | | | | | | Comparative example | | | |
|---|---|---|---|---|---|---|---|---|---|---|---|---|
| | | | 1 | 2 | 3 | 4 | 5 | 6 | 1 | 2 | 3 | 4 |
| Composition of radiation-sensitive resin composition | | | | | | | | | | | | |
| | Cyclic olefin polymer (A-1) | (parts) | 100 | 100 | 100 | 100 | 100 | 100 | 100 | 100 | 100 | |
| | Acrylic polymer | (parts) | | | | | | | | | | 100 |
| | Bifunctional chain epoxy compound (jER YX7400) | (parts) | 10 | 30 | 50 | 80 | 50 | 130 | | | | |
| | Aliphatic cyclic 4-functional epoxy resin (GT401) | (parts) | | | | | 20 | | | | 50 | |
| | Epoxy compound having naphthalene skeleton (HP4700) | (parts) | | | | | | | 50 | | | |
| | Long chain bisphenol A type epoxy resin (EXA-4850-1000) | (parts) | | | | | | | | 50 | | |
| | Radiation-sensitive compound (TS200) | (parts) | 30 | 30 | 30 | 30 | 30 | 30 | 30 | 30 | 30 | 30 |
| | Methoxymethyl group-containing cross-linking agent (MW-100LM) | (parts) | 10 | 10 | 10 | 10 | 10 | 10 | 10 | 10 | 10 | 10 |
| | γ-glycidoxypropyltrimethoxysilane | (parts) | 2 | 2 | 2 | 2 | 2 | 2 | 2 | 2 | 2 | 2 |

| Evaluation | | | | | | | | | | | | |
|---|---|---|---|---|---|---|---|---|---|---|---|---|
| | Tensile modulus (warping inhibiting effect) | | B | A | A | A | A | A | C | B | B | C |
| | Thermal shock resistance | | B | A | A | A | AA | A | C | B | C | C |
| | Developability | | A | A | A | A | A | A | C | C | A | A |
| | Solder heat resistance | | AA | AA | AA | A | AA | C | AA | B | AA | B |

As shown in Table 1, a resin film obtained using a radiation-sensitive resin composition comprised of a cyclic olefin polymer (A) having a protonic polar group, a bifunctional epoxy compound (B) represented by the above general formula (1), and a radiation-sensitive compound (C) was low in elastic modulus and suppressed in occurrence of warping due to this and, further, was excellent in thermal shock resistance and developability (Examples 1 to 6). Further, Examples 2 to 5 having contents of bifunctional epoxy compound (B) represented by the above general formula (1) made specific ranges was low in elastic modulus, particularly excellent in thermal shock resistance, and, further, excellent in solder heat resistance as well.

On the other hand, if using another epoxy compound instead of the bifunctional epoxy compound (B) represented by the above general formula (1), the result was that the obtained resin film was high in elastic modulus or was inferior in either of the thermal shock resistance or developability (Comparative Examples 1 to 3).

Further, if using an acrylic polymer instead of the cyclic olefin polymer (A) having a protonic polar group, the obtained resin film was inferior in thermal shock resistance and developability (Comparative Example 4).

## Claims

1. A radiation-sensitive resin composition comprising a cyclic olefin polymer (A) having a protonic polar group, a bifunctional epoxy compound (B) represented by the following general formula (1), and a radiation-sensitive compound (C): 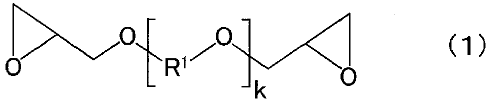 wherein, in the general formula (1), R¹ is a linear chain or branched alkylene group having 1 to 15 carbon atoms and "k" is an integer of 1 to 20.

2. The radiation-sensitive resin composition according to claim 1, wherein a content of the epoxy compound (B) is 8 to 150 parts by weight with respect to 100 parts by weight of the cyclic olefin polymer (A) having a protonic polar group.

3. The radiation-sensitive resin composition according to claim 1 or 2, wherein an epoxy equivalent of the epoxy compound (B) is 100 to 1000.

4. The radiation-sensitive resin composition according to any one of claims 1 to 3, wherein a softening point of the epoxy compound (B) is 40°C or less.

5. The radiation-sensitive resin composition according to any one of claims 1 to 4 further comprising a compound including two or more alkoxymethyl groups or methylol groups in its molecule.

6. The radiation-sensitive resin composition according to any one of claims 1 to 5 further comprising an epoxy compound having an alicyclic structure.

7. The radiation-sensitive resin composition according to any one of claims 1 to 6 further comprising a silane coupling agent.

8. An electronic device provided with a resin film comprised of a radiation-sensitive resin composition according to any one of claims 1 to 7.
